(19) Europäisches Patentamt
European Patent Office
Office européen des brevets

(11) EP 0 860 743 A2

(12) EUROPEAN PATENT APPLICATION

(43) Date of publication:
26.08.1998 Bulletin 1998/35

(51) Int. Cl.[6]: G03F 7/26

(21) Application number: 98103054.7

(22) Date of filing: 20.02.1998

(84) Designated Contracting States:
AT BE CH DE DK ES FI FR GB GR IE IT LI LU MC NL PT SE
Designated Extension States:
AL LT LV MK RO SI

(30) Priority: 25.02.1997 JP 40210/97

(71) Applicant:
MATSUSHITA ELECTRIC INDUSTRIAL CO., LTD.
Kadoma-shi, Osaka 571 (JP)

(72) Inventors:
- Matsuo, Takahiro
Uji-shi, Kyoto 611 (JP)
- Endo, Masayuki
Izumi-shi, Osaka 594 (JP)
- Shirai, Masamitsu
Ibaraki-shi, Osaka 568 (JP)
- Tsunooka, Masahiro
Sennan-shi, Osaka 590-05 (JP)

(74) Representative:
Grünecker, Kinkeldey,
Stockmair & Schwanhäusser
Anwaltssozietät
Maximilianstrasse 58
80538 München (DE)

# (54) Pattern forming method and semiconductor processing method

(57) A resist film which generates a sulfonic acid through irradiation with an energy beam is irradiated with a KrF excimer laser beam through a mask to generate a sulfonic acid in the exposed area. Then, a semiconductor substrate is immersed in a solution of polysiloxane having an amino group, and dried. This causes the electrostatic adsorption of the polysiloxane having an ammonium ion on the surface of the exposed area of the resist film where a sulfonic acid ion is present to form a polysiloxane film. Thereafter, the resist film is subjected to $O_2$ plasma etching by using the polysiloxane film as a mask to form a resist pattern.

Fig. 3

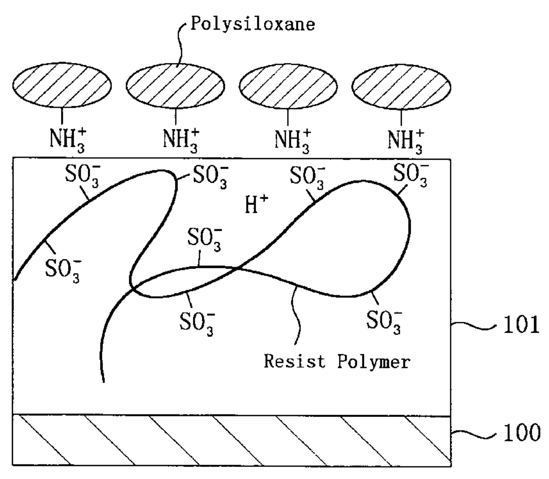


EP 0 860 743 A2

## Description

### BACKGROUND OF THE INVENTION

The present invention relates to a pattern forming method and a semiconductor processing method adaptable in a manufacturing process for a semiconductor IC and the like.

In the manufacture of ICs, LSIs and the like, a pattern is conventionally formed through photolithography using UV, in which a light source with a shorter wavelength has become mainly used in accordance with miniaturization of a semiconductor device. A surface imaging process using dry development has been developed in order to improve the resolution and increase the depth of focus in using a light source with a shorter wavelength.

As an example of the surface imaging process, U.S. Patent No. 5,278,029 discloses a method wherein a polysiloxane film is selectively formed on the surface of a resist film which can generate an acid through exposure, after which the resist film is dry etched by using the polysiloxane film as a mask to form a resist pattern. Below, this conventional method will be described with reference to FIGS. 12(a) through 12(c).

In this method, a copolymer of 1,2,3,4-tetrahydronaphthyridinenimino-p-styrene sulfonate (NISS) and methyl methacrylate (MMA) is used as the resist material for generating an acid through exposure.

First, as is shown in FIG. 12(a), a resist film 11, which generates an acid through exposure, coated on a silicon substrate 10 is irradiated with a KrF excimer laser 13 by using a mask 12, resulting in the generation of an acid 14 to be a catalyst in the exposed area of the resist film 11. Owing to the acid 14, the exposed area of the resist film 11 is changed to be hydrophilic, and hence water in air is adsorbed on the surface of the exposed area.

Next, as is shown in FIG. 12(b), when an alkoxysilane gas 15 is introduced onto the surface of the resist film 11 by a CVD method, the acid 14 generated on the surface of the exposed area of the resist film 11 works as a catalyst, so that alkoxysilane is hydrolyzed and condensed. As a result, a polysiloxane film 16 is formed on the surface of the exposed area.

Subsequently, as is shown in FIG.12(c), when the resist film 11 is dry etched by RIE using $O_2$ plasma 17 by using the polysiloxane film 16 as a mask, a fine-line resist pattern 18 is formed on the exposed area of the resist film 11.

However, when a resist pattern is formed in accordance with the aforementioned method, the acid which has been selectively generated on the exposed area of the resist film 11 works as a catalyst, so that alkoxysilane, which is a raw material, is hydrolyzed and condensed to produce polysiloxane. Accordingly, as is shown in FIG. 13, polysiloxane is linearly formed with respect to the CVD processing time (alkoxysilane gas introducing time). The reason for this is that alkoxysilane polymerizes with the nucleus of polysiloxane during the CVD process, which allows the growth of polysiloxane to proceed.

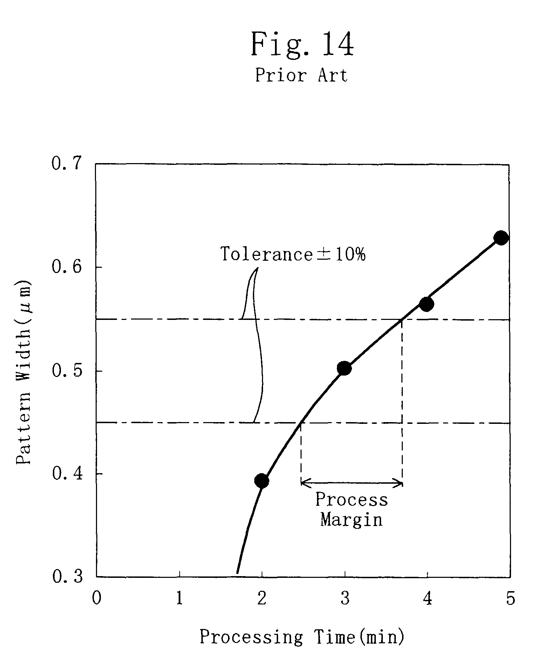

FIG. 14 shows the relationship between the CVD processing time and the actual values of a pattern width with 0.5-$\mu$m design rules. If the tolerance on the pattern width is assumed to be 0.5 $\mu$m $\pm$ 10%, the process margin for the CVD processing time becomes 3 minutes $\pm$ 30 seconds. As described above, the amount of alkoxysilane to undergo polymerization reaction depends on the CVD processing time, and hence the process margin for the CVD processing time is very narrow as is evident from FIG. 14. If the process margin for the CVD processing time is narrow, there occurs a disadvantage in that variations in pattern width in a wafer plane, between wafers, and between batches increase, thereby reducing the yield of semiconductor devices to be obtained.

### SUMMARY OF THE INVENTION

The present invention has been achieved in view of the foregoing. It is therefore an object of the present invention to process a thin film such as resist film deposited on a semiconductor substrate or an object film formed on the semiconductor substrate, thereby reducing the processing time dependence of the thin film width in forming a compound film made of the thin film for a mask.

In order to achieve the forgoing object, the present invention provides a method of selectively imparting a positive or negative electric charge to the surface of a thin film such as resist film to be a mask, and supplying a compound having a negative or positive electric charge onto the entire surface of the thin film to cause the electrostatic adsorption of the positive or negative electric charge of the thin film with the negative or positive electric charge of the compound, thereby forming a compound film only in the region where a positive or negative electric charge has been imparted on the surface of the thin film.

A pattern forming method according to the present invention comprises: a resist film depositing step of depositing a resist film on an object film formed on a semiconductor substrate; a charging step of selectively imparting a positive or negative electric charge to the surface of the resist film; an inorganic compound film forming step of supplying an inorganic compound having an opposite charge to the charge which has been imparted in the charging step onto the entire surface of the resist film to cause the electrostatic adsorption of the inorganic compound on the surface of the resist film charged in the charging step, thereby selectively forming an inorganic compound film made of the inorganic

compound on the surface of the resist film; and an etching step of subjecting the resist film to dry etching by using the inorganic compound film as a mask to form a resist pattern made of the resist film.

With the pattern forming method according to the present invention, when the entire surface of the resist film is supplied with an inorganic compound having an opposite charge to the charge which has been imparted to the resist film, on the selectively charged region in the surface of the resist film, the inorganic compound having an opposite charge is electrostatically adsorbed. Accordingly, an inorganic compound film made of the inorganic compound can be selectively formed on the surface of the resist film, and hence a resist pattern with high resolution can be formed. In this case, the electrostatic adsorption instantaneously occurs, and is instantaneously saturated, and hence the amount of the inorganic compound formed on the surface of the resist film is also saturated. Therefore, the width of the inorganic compound film selectively formed on the surface of the resist film coincides with the width of the charged region in the resist film. Since the width of the inorganic compound film will not be influenced by the processing temperature and processing time for forming the inorganic compound film, it will not be also influenced by variations in processing temperature and processing time, thereby improving the controllability of the width of the resist pattern.

In the pattern forming method according to the present invention, it is preferable that the resist film in the resist depositing step comprises a resist material which generates a negative ion through irradiation with an energy beam; the charging step includes a step of selectively irradiating the surface of the resist film with an energy beam to selectively generate a negative ion on the surface of the resist film; and the inorganic compound film forming step includes a step of supplying an inorganic compound for generating a positive ion onto the entire surface of the resist film to cause the electrostatic adsorption of the inorganic compound in which a positive ion has been generated on the surface of the resist film in which a negative ion has been generated.

Thus, the resist film can be selectively charged through irradiation with an energy beam, and hence the width of the inorganic compound film selectively formed on the surface of the resist film can be controlled with ease and reliability.

In this case, it is preferable that the resist film comprises a polymer having a negative ion generating group which generates a negative ion through irradiation with an energy beam.

Thus, a negative ion is generated in the polymer, and hence there is no possibility that the negative ion vaporizes and disappears, thereby further improving the controllability of the width of the resist pattern.

It is more preferable that the polymer having the negative ion generating group generates a sulfonic acid ion or a carboxylic acid ion through irradiation with an energy beam.

Thus, the negative ion is generated with reliability, and hence the electrostatic adsorption can be performed with reliability. In other words, the electrostatically adsorbing force can be enhanced.

It is preferable that the inorganic compound is a compound having an amino group. Thus, an ammonium ion is generated from the inorganic compound, and hence the electrostatic adsorption can be performed with reliability. In other words, the electrostatically adsorbing force can be enhanced.

In the pattern forming method according to the present invention, it is preferable that the resist film in the resist film depositing step comprises a resist material which generates a positive ion through irradiation with an energy beam; the charging step includes a step of selectively irradiating the surface of the resist film with an energy beam to selectively generate a positive ion on the surface of the resist film; and the inorganic compound film forming step includes a step of supplying an inorganic compound for generating a negative ion on the entire surface of the resist film to cause the electrostatic adsorption of the inorganic compound in which a negative ion has been generated on the surface of the resist film in which a positive ion has been generated.

Thus, the resist film can be selectively charged through irradiation with an energy beam, and hence the width of the inorganic compound film selectively formed on the surface of the resist film can be controlled with ease and reliability.

In this case, it is preferable that the resist film comprises a polymer having a positive ion generating group which generates a positive ion through irradiation with an energy beam.

Thus, a positive ion is generated in the polymer, and hence there is no possibility that the positive ion vaporizes and disappears, thereby further improving the controllability of the width of the resist pattern.

It is preferable that the polymer having the positive ion generating group generates an ammonium ion through irradiation with an energy beam

Thus, the positive ion is generated with reliability, and hence the electrostatic adsorption can be performed with reliability. In other words, the electrostatically adsorbing force can be enhanced.

It is preferable that the inorganic compound is a compound having a sulfonic group or a carboxylic group. Thus, an ammonium ion is generated from the inorganic compound, and hence the electrostatic adsorption can be performed with reliability. In other words, the electrostatically adsorbing force can be enhanced.

In the pattern forming method according to the present invention, it is preferable that the inorganic film forming step includes a step of supplying a solution of the inorganic compound onto the entire surface of the resist film. Thus, the inorganic compound can be supplied onto the entire surface thereof with ease and reliability.

In the pattern forming method according to the present invention, it is preferable that the inorganic film forming step includes a step of supplying the vapor of the inorganic compound onto the entire surface of the resist film. Thus, the

amount of the inorganic compound to be used in processing can be reduced, resulting in a reduction in cost required for the processing.

In the pattern forming method according to the present invention, it is preferable that the charging step includes a step of selectively implanting a positive or negative ion into the surface of the resist film to selectively impart a positive or negative electric charge to the surface of the resist film.

Thus, the resist film can be selectively charged by ion implantation, and hence the width of the inorganic compound film selectively formed on the surface of the resist film can be controlled with ease and reliability.

A semiconductor processing method according to the present invention comprises: a thin film depositing step of depositing a thin film on a semiconductor substrate, or an object film formed on the semiconductor substrate; a charging step of selectively imparting a positive or negative electric charge to the surface of the thin film; a compound film forming step of supplying a compound having an opposite charge to the charge which has been imparted in the charging step onto the entire surface of the thin film to cause the electrostatic adsorption of the compound having the opposite charge on the surface of the thin film charged in the charging step, thereby selectively forming a compound film made of the compound on the surface of the thin film; and a processing step of processing the semiconductor substrate or the object film by using the compound film as a mask.

With the semiconductor processing method according to the present invention, when the entire surface of the thin film is supplied with a compound having an opposite charge to the charge which has been imparted to the thin film, on the selectively charged region in the surface of the thin film, the compound having an opposite charge is electrostatically adsorbed, and hence a compound film made of the compound can be selectively formed on the surface of the thin film. Therefore, the semiconductor substrate or the object film can be subjected to processing with high precision. In this case, the electrostatic adsorption instantaneously occurs and is instantaneously saturated, and hence the amount of the compound adsorbed on the surface of the thin film is saturated. Accordingly, the width of the compound film selectively formed on the surface of the thin film coincides with the width of the charged region in the thin film. Since the width of the compound film will not be influenced by the processing temperature and processing time for forming the compound film, it will not be also influenced by variations in processing temperature and processing time, thereby improving the controllability of the width in the processed region.

In the semiconductor processing method according to the present invention, it is preferable that the charging step includes a step of selectively implanting a positive or negative ion into the surface of the thin film to selectively impart a positive or negative electric charge to the surface of the thin film.

Thus, the thin film can be selectively charged by ion implantation, and hence the width of the compound film selectively formed on the surface of the thin film can be controlled with ease and reliability.

BRIEF DESCRIPTION OF THE DRAWINGS

FIGS. 1(a) and 1(b) are sectional views for showing procedures of a pattern forming method according to a first embodiment of the present invention;

FIGS. 2(a) and 2(b) are sectional views for showing procedures of the pattern forming method according to the first embodiment of the present invention;

FIG. 3 is a view for illustrating the mechanism of the electrostatic adsorption of polysiloxane in the pattern forming method according to the first embodiment of the present invention;

FIG. 4 is a diagram for showing the relationship between the amount of polysiloxane electrostatically adsorbed by the pattern forming method according to the first embodiment of the present invention and the processing time thereof;

FIG. 5 is a diagram for showing the relationship between the width of a pattern formed by the pattern forming method according to the first embodiment of the present invention and the processing time thereof;

FIGS. 6(a) and 6(b) are sectional views for showing procedures of a pattern forming method according to a second embodiment of the present invention;

FIGS. 7(a) and 7(b) are sectional views for showing procedures of the pattern forming method according to the second embodiment of the present invention;

FIGS. 8(a) and 8(b) are sectional views for showing procedures of a pattern forming method according to a third embodiment of the present invention;

FIGS. 9(a) and 9(b) are sectional views for showing procedures of the pattern forming method according to the third embodiment of the present invention;

FIGS. 10(a) and 10(b) are sectional views for showing procedures of a pattern forming method according to a fourth embodiment of the present invention;

FIGS. 11(a) and 11(b) are sectional views for showing procedures of the pattern forming method according to the fourth embodiment of the present invention;

FIGS. 12(a) through 12(c) are sectional views for showing procedures of a conventional pattern forming method;

FIG. 13 is a diagram for showing the relationship between the amount of polysiloxane formed by the conventional pattern forming method and the processing time thereof; and

FIG. 14 is a diagram for showing the relationship between the width of a pattern formed by the conventional pattern forming method and the processing time thereof.

## DETAILED DESCRIPTION OF THE PREFERRED EMBODIMENTS

(Embodiment 1)

FIGS. 1(a) and 1(b), and FIGS. 2(a) and 2(b) are sectional views for showing procedures of a pattern forming method according to a first embodiment of the present invention.

As a resist material, a copolymer of 1,2,3,4-tetrahydronaphthyridinenimino-p-styrene sulfonate (NISS) and methyl methacrylate (MMA) dissolved in ECA is used. In this case, the NISS content is 24 mol%.

As an inorganic compound, polysiloxane obtained by polymerizing 3-aminopropyltriethoxysilane by the use of hydrochloric acid serving as a catalyst is used.

First, as is shown in FIG. 1(a), the resist material is spin-coated on a semiconductor substrate 100 of silicon, and the resultant semiconductor substrate 100 is annealed at a temperature of 90°C for 90 seconds, thereby forming a resist film 101 with a thickness of 1 μm. Then, by using a mask 102, the resist film 101 is irradiated with a KrF excimer laser 103, i.e., an energy beam, thereby transcribing a pattern of the mask 102 on the resist film 101. In this manner, NISS is dissolved to generate a sulfonic acid ion 104, i.e., a negative ion on the surface of an exposed area of the resist film 101.

Next, the semiconductor substrate 100 is immersed in a 0.1N solution of TPAH ($HON(CH_2CH_2CH_3)_4$) for 5 minutes, and then washed with water, after which the semiconductor substrate 100 is immersed in a polysiloxane solution 106 obtained by diluting polysiloxane 105 having an amino group with water as is shown in FIG. 1(b). Thereafter, the semiconductor substrate 100 is washed with water, and then dried. Conducting such processing causes the polysiloxane 105 having an ammonium ion 107, i.e., a positive ion, to be electrostatically adsorbed on the surface of the exposed area of the resist film 101 where a sulfonic acid ion 104, i.e., a negative ion is present, resulting in the formation of a polysiloxane film 108, as is shown in FIG. 2(a).

Next, as is shown in FIG. 2(b), by using the polysiloxane film 108 as a mask, the resist film 101 is subjected to RIE (reactive ion etching) using $O_2$ plasma 109, thereby forming a resist pattern 110. In this case, the RIE using $O_2$ plasma 109 is effected by using a parallel plate reactive ion etching system under conditions of a power of 900 W, a pressure of 0.7 Pa and a flow rate of 40 SCCM.

Below, a description will be given to the mechanism whereby the processing of the resist film 101 with the polysiloxane solution 106 selectively causes the electrostatic adsorption of the polysiloxane with reference to FIG. 3. Through exposure by means of the KrF excimer laser 103, as is shown in the following [Chemical Formula 1], on the surface of the exposed area of the resist film 101, NISS is dissolved, and the dissolved NISS is influenced by slightly adsorbed water to generate a substance including a sulfonic acid ion ($SO_3^-$) 104, i.e., a negative ion, a hydrogen ion $H^+$, and a reaction by-product represented by the following [Chemical Formula 2], followed by volatilization of the reaction by-product.

[Chemical Formula 1]

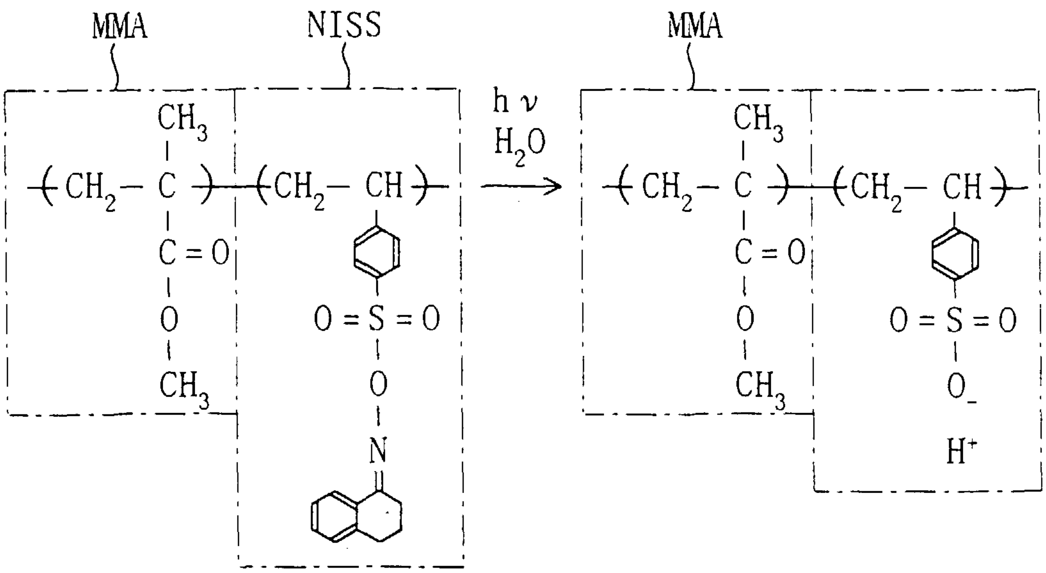


[Chemical Formula 2]

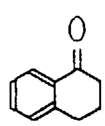

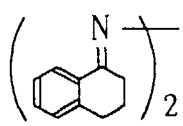

On the other hand, as is shown in [Chemical Formula 3], the polysiloxane 105 having an amino group occurs with having an ammonium ion ($NH_3^+$) 107, i.e., a positive ion in the polysiloxane solution 106.

[Chemical Formula 3]

$$\overset{+}{N}H_3-R(Si-O-Si)_n$$

wherein R is $C_3H_6$

Therefore, as is shown in FIG. 3, one polysiloxane 105 having an ammonium ion (positive ion) 107 is electrostatically adsorbed on one sulfonic acid ion 104 (negative ion) existing on the surface of the exposed area of the resist film 101,. In this manner, each polysiloxane 105 is electrostatically adsorbed on every sulfonic acid ion 104 existing on the surface of the exposed area of the resist film 101, respectively,. Accordingly, when the electrostatic adsorption proceeds, resulting in no presence of the sulfonic acid ion 104 on the surface of the exposed area of the resist film 101, the electrostatic adsorption will no more occur. Consequently, even after an elapse of the processing time, the polysiloxane film 108 will no more expand.

The amount of the polysiloxane film 108 formed through electrostatic adsorption caused by the aforementioned method is evaluated by measuring the absorbing peak of the siloxane bond by FTIR (Fourier transform infrared spectroscopy).

FIG. 4 shows the relationship between the processing time with the polysiloxane solution 106 and the amount of the formed polysiloxane film 108 in the exposed area and unexposed area of the resist film 101. As is shown in FIG. 4, in the unexposed area where the sulfonic acid ion 104 is not generated, there is no formation of the polysiloxane film 108 even after the processing time has appreciably elapsed. On the other hand, in the exposed area of the resist film

101, the polysiloxane film 108 is formed instantaneously (within 30 seconds), and no change is observed in amount of the formed polysiloxane film 108 even after the processing time has exceeded 30 seconds. It is also indicated that the selectivity between the exposed area and unexposed area in the resist film 101 is very high.

FIG. 5 shows the relationship between the processing time with the polysiloxane solution 106 and the pattern width(0.5-μm design rules) of the resist pattern 110 when etching has been conducted after causing the electrostatic adsorption of the polysiloxane 105. As described above, the amount of the formed polysiloxane 107 is completely saturated with respect to the processing time, and hence, it is indicated that variations in pattern width are very small as is shown in FIG. 5. The variations in pattern width satisfy the tolerance on the pattern width (within ±10%) to a sufficient degree.

In this manner, according to the first embodiment, the sulfonic acid ion 104, i.e., a negative ion, is selectively generated on the surface of the exposed area of the resist film 101, and the polysiloxane 105 having an ammonium ion 107, i.e., a positive ion is caused to be electrostatically adsorbed on the sulfonic acid ion 104. Accordingly, the width of the selectively formed polysiloxane film (inorganic compound film) 108 is uniquely determined by the amount of the generated negative ions. Therefore, it is difficult for the resist film 101 to be influenced by the variations in processing temperature and processing time of the electrostatic adsorption, resulting in an improvement in controllability of the pattern width.

Since the processing with the polysiloxane solution 106 is easy and simple, and the amount of the formed polysiloxanes 105 is instantaneously saturated, the processing time is terminated in a short time, resulting in high throughput.

Further, in the unexposed area of the resist film 101 where no sulfonic acid ion 104 is present, even if the polysiloxane 105 having an ammonium ion 107, i.e., a positive ion is supplied, there will not occur electrostatic adsorption due to no presence of negative ion, resulting in very high selectivity between the exposed area and unexposed area.

In the first embodiment, as a resist material, a copolymer of NISS and MMA is used, but a group which can generate an acid through exposure can be used in place of NISS appropriately. For example, as an acid generating group, 9-fluorenilideneimino-p-styrene sulfonate (FISS), or propylideneimino-p-styrene sulfonate (PISS) may be used. In place of MMA, the substances to produce a copolymer with NISS such as styrene can be used appropriately.

The polysiloxane having an amino group is used in this embodiment, but inorganic compounds having other groups to be positive ions may be used instead. For example, a high molecular compound having an amino group, and including Ti, Al, Ge, or Zr may be used.

As a processing method with an inorganic compound, the processing is performed by the use of a solution of inorganic compound in this embodiment, but the processing may be performed by using vapor of inorganic compound instead.

Also, the dry development is effected by the RIE using $O_2$ plasma in this embodiment, but ECR (electron cyclotron resonance etching) using $O_2$ plasma or the like is adoptable instead.

Moreover, a light source for the exposure is the KrF excimer laser in this embodiment, but , an ArF excimer laser, an electron beam, or X-rays can be used instead.

(Embodiment 2)

FIGS. 6(a) and 6(b), and FIGS. 7(a) and 7(b) are sectional views for showing procedures of a pattern forming method according to a second embodiment of the present invention.

As a resist material, a copolymer of NISS and styrene dissolved in diglyme is used. In this case, the NISS content is 55 mol%.

As an inorganic compound, polysiloxane obtained by polymerizing 3-aminopropyltriethoxysilane by the use of hydrochloric acid serving as a catalyst is used.

In the same manner as in the first embodiment, as is shown in FIG. 6(a), the resist material is spin-coated on a semiconductor substrate 200 of silicon, and the resultant semiconductor substrate 200 is annealed at a temperature of 90°C for 90 seconds, thereby forming a resist film 201 with a thickness of 1 μm. Then, by using a mask 202, the resist film 201 is irradiated with an ArF excimer laser 203, i.e., an energy beam, thereby exposing a pattern of the mask 202 on the resist film 201. In this manner, NISS is dissolved to generate a sulfonic acid ion 204, i.e., a negative ion on the surface of an exposed area of the resist film 201.

Next, the vapor of polysiloxane 205 having an amino group is sprayed on the surface of the resist film 201 as is shown in FIG. 6(b). In this step, the amino group becomes an ammonium ion 207, i.e., a positive ion due to the moisture in an atmosphere, resulting in that the polysiloxane 205 has a positive ion. Conducting such a processing causes the polysiloxane 205 in the vapor form having an ammonium ion 207, i.e., a positive ion, to be electrostatically adsorbed on the surface of the exposed area of the resist film 201 where a negative ion is present, resulting in the formation of a polysiloxane film 208, as is shown in FIG. 7(a).

Next, as is shown in FIG. 7(b), by using the polysiloxane film 208 as a mask, the resist film 201 is subjected to RIE using $O_2$ plasma 209, thereby forming a resist pattern 210. In this case, the RIE using $O_2$ plasma 209 is effected by

using a parallel plate reactive ion etching system under conditions of a power of 900 W, a pressure of 0.7 Pa and a flow rate of 40 SCCM.

In this manner, according to the second embodiment, the sulfonic acid ion 204, i.e., a negative ion, is selectively generated on the surface of the exposed area of the resist film 201, and the polysiloxane 205 having an ammonium ion 207, i.e., a positive ion is caused to be electrostatically adsorbed on the sulfonic acid ion 204. Accordingly, the width of the selectively formed polysiloxane film (inorganic compound film) 208 is uniquely determined by the amount of the generated negative ions. Therefore, it is difficult for the resist film 201 to be influenced by the variations in processing temperature and processing time of the electrostatic adsorption, resulting in an improvement in controllability of the pattern width.

Since the processing for causing the electrostatic adsorption of the polysiloxane 205 having an amino group is effected by supplying the polysiloxane 205 in the vapor form, only a slight amount of polysiloxane material is required for the processing, offering an advantage of low cost.

Further, in the unexposed area of the resist film 201 where no sulfonic acid ion 204 is present, even if the polysiloxane 205 having an ammonium ion 207, i.e., a positive ion is supplied, there will not occur electrostatic adsorption due to no presence of negative ion, resulting in very high selectivity between the exposed area and unexposed area.

In the second embodiment, as a resist material, a copolymer of NISS and styrene is used, but a group which can generate an acid through exposure can be used in place of NISS appropriately. For example, as an acid generating group, 9-fluorenilideneimino-p-styrene sulfonate (FISS), or propylideneimino-p-styrene sulfonate (PISS) may be used.

The polysiloxane having an amino group is used in this embodiment, but inorganic compounds having other groups to be positive ions may be used instead. For example, a high molecular compound having an amino group, and including Ti, Al, Ge, or Zr may be used.

As a processing method with an inorganic compound, the processing is performed by the use of the vapor of inorganic compound in this embodiment, but processing may be performed by using a solution of inorganic compound instead.

Also, the dry development is effected by the RIE using $O_2$ plasma in this embodiment, but ECR (electron cyclotron resonance etching) using $O_2$ plasma or the like is adoptable instead.

Moreover, a light source for the exposure is the ArF excimer laser in this embodiment, but, a KrF excimer laser, an electron beam, or X-rays can be used instead.

(Embodiment 3)

FIGS. 8(a) and 8(b), and FIGS. 9(a) and 9(b) are sectional views for showing procedures of a pattern forming method according to a third embodiment of the present invention.

As a resist material, a copolymer of O-acryloyl-acetophenone-oxime (AAPO) and MMA dissolved in diglyme is used. In this case, the AAPO content is 34 mol%.

As an inorganic compound, polysiloxane having a sulfonic group is used.

First, as is shown in FIG. 8(a), the resist material is spin-coated on a semiconductor substrate 300 of silicon, and the resultant semiconductor substrate 300 is annealed at a temperature of 90°C for 90 seconds, thereby forming a resist film 301 with a thickness of 1 μm. Then, by using a mask 302, the resist film 301 is irradiated with a KrF excimer laser 303, i.e., an energy beam, thereby exposing a pattern of the mask 302 on the resist film 301. In this manner, AAPO is dissolved, and the dissolved AAPO is influenced by water to generate an ammonium ion 304, i.e., a positive ion on the surface of an exposed area of the resist film 301.

Next, the semiconductor substrate 300 is immersed in a polysiloxane solution 306 obtained by diluting polysiloxane 305 having a sulfonic group with water as is shown in FIG. 8(b). Thereafter, the semiconductor substrate 300 is washed with water, and then dried. Conducting such a processing causes the polysiloxane 305 having a sulfonic acid ion 307, i.e., a negative ion, to be electrostatically adsorbed on the surface of the exposed area of the resist film 301 where an ammonium ion 304, i.e., a positive ion is present, resulting in the formation of a polysiloxane film 308, as is shown in FIG. 9(a).

Next, as is shown in FIG. 9(b), by using the polysiloxane film 308 as a mask, the resist film 301 is subjected to RIE using $O_2$ plasma 309, thereby forming a resist pattern 310. In this case, the RIE using $O_2$ plasma 309 is effected by using a parallel plate reactive ion etching system under conditions of a power of 900 W, a pressure of 0.7 Pa and a flow rate of 40 SCCM.

In this manner, according to the third embodiment, the ammonium ion 304, i.e., a positive ion, is selectively generated on the surface of the exposed area of the resist film 301, and the polysiloxane 305 having a sulfonic acid ion 307, i.e., a negative ion is caused to be electrostatically adsorbed on the ammonium ion 304. Accordingly, the width of the selectively formed polysiloxane film (inorganic compound film ) 308 is uniquely determined by the amount of the generated positive ions. Therefore, it is difficult for the resist film 301 to be influenced by the variations in processing temperature and processing time of the electrostatic adsorption, resulting in an improvement in controllability of the pattern

width.

Since the processing with the polysiloxane solution 306 is easy and simple, and the amount of the formed polysiloxanes 305 is instantaneously saturated, the processing time is terminated in a short time, resulting in high throughput.

Further, in the unexposed area of the resist film 301 where no ammonium ion 304 is present, even if the polysiloxane 305 having a sulfonic acid ion 307, i.e., a negative ion is supplied, there will not occur electrostatic adsorption due to no presence of positive ion, resulting in very high selectivity between the exposed area and unexposed area.

In the third embodiment, as a resist material, a copolymer of AAPO and MMA is used, but a group which can generate a base through exposure can be used in place of AAPO appropriately. For example, as a base generating group, O-phenylacetyl-acetophenone-oxime (PaApO), or O-phenylacetyl-acetonaphthone-oxime (PaANO) may be used.

The polysiloxane having a sulfonic group is used in this embodiment, but inorganic compounds having other groups to be negative ions such as carboxylic group may be used instead. For example, a high molecular compound having a sulfonic group or carboxylic group, and including Ti, Al, Ge, or Zr may be used.

As a processing method with an inorganic compound, the processing is performed by the use of a solution of inorganic compound in this embodiment, but the processing may be performed by using the vapor of inorganic compound instead.

Also, the dry development is effected by the RIE using $O_2$ plasma in this embodiment, but ECR (electron cyclotron resonance etching) using $O_2$ plasma or the like is adoptable instead.

Moreover, a light source for the exposure is the KrF excimer laser in this embodiment, but , an ArF excimer laser, an electron beam, or X-rays can be used instead.

(Embodiment 4)

FIGS. 10(a) and 10(b), and FIGS. 11(a) and 11(b) are sectional views for showing procedures of a pattern forming method according to a fourth embodiment of the present invention.

As a resist material, novolak type resin dissolved in diglyme is used.

As an inorganic compound, polysiloxane having a sulfonic group is used.

First, as is shown in FIG. 10(a), the resist material is spin-coated on a semiconductor substrate 400 of silicon, and the resultant semiconductor substrate 400 is annealed at a temperature of 200°C for 90 seconds, thereby forming a resist film 401 with a thickness of 1 μm. Thereafter, a desired pattern is exposed by means of a hydrogen ion beam 403, thereby selectively implanting hydrogen ions ($H^+$) 404 into the vicinity of the surface of the resist film 401. In this step, the resist film 401 is an insulating film, and hence the implanted hydrogen ion 404 remains as a positive electric charge.

Next, the vapor of polysiloxane 405 having a sulfonic group is sprayed on the surface of the resist film 401 as is shown in FIG. 10(b). In this step, the sulfonic group becomes a sulfonic acid ion 407, i.e., a negative ion due to the moisture in an atmosphere, resulting in that the polysiloxane 405 has a negative ion. Conducting such a processing causes the polysiloxane 405 in the vapor form having a sulfonic acid ion 407, i.e., a negative ion, to be electrostatically adsorbed on the surface of the exposed area of the resist film 401 where the hydrogen ion 404, i.e., a positive ion is present, resulting in the formation of a polysiloxane film 408, as is shown in FIG.11(a).

Next, as is shown in FIG. 11(b), by using the polysiloxane film 408 as a mask, the resist film 401 is subjected to RIE using $O_2$ plasma 409, thereby forming a resist pattern 410. In this case, the RIE using $O_2$ plasma 409 is effected by using a parallel plate reactive ion etching system under conditions of a power of 900 W, a pressure of 0.7 Pa and a flow rate of 40 SCCM.

In this manner, according to the fourth embodiment, the hydrogen ion 404, i.e., a positive ion, is selectively implanted into the surface of the exposed area of the resist film 401, and the polysiloxane 405 having a sulfonic acid ion 407, i.e., a negative ion is caused to be electrostatically adsorbed on the hydrogen ion 404. Accordingly, the width of the selectively formed polysiloxane film (inorganic compound film) 408 is uniquely determined by the amount of ions of the implanted hydrogen ions 404. Therefore, it is difficult for the resist film 401 to be influenced by the variations in processing temperature and processing time of the electrostatic adsorption, resulting in an improvement in controllability of the pattern width.

Since the processing of the electrostatic adsorption of the polysiloxane 405 having a sulfonic group is effected by supplying the polysiloxane 405 in the vapor form, only a slight amount of polysiloxane material is required for the processing, offering an advantage of low cost.

Further, in the unexposed area of the resist film 401 where no hydrogen ion 404 has been implanted, even if the polysiloxane 405 having a sulfonic acid ion 407, i.e., a negative ion, is supplied, there will not occur electrostatic adsorption due to no presence of positive ion, resulting in very high selectivity between the exposed area and unexposed area.

The polysiloxane having a sulfonic group is used in this embodiment, but inorganic compounds for generating a negative ion opposite to the positive ion for ion implantation may be used instead. For example, a high molecular compound having a carboxylic group, and including Ti, Al, Ge, or Zr may be used.

Also, a hydrogen ion is used as an ion to be selectively implanted into the resist film 401 in this embodiment, but a

He ion having a positive electric charge, C ion having a positive or negative electric charge, or the like may be used instead. When a negative ion is implanted, in place of polysiloxane having a sulfonic group which generates a negative ion, for example, polysiloxane having an amino group, or a high molecular compound having an amino group, and including Ti, Al, Ge, or Zr may be used.

As a processing method with an inorganic compound, the processing is performed by the use of the vapor of inorganic compound in this embodiment, but processing may be performed by using a solution of inorganic compound instead.

Also, the dry development is effected by the RIE using $O_2$ plasma in this embodiment, but ECR (electron cyclotron resonance etching) using $O_2$ plasma or the like is adoptable instead.

In the first through fourth embodiments, a description was given to only a method of subjecting a resist film to dry etching to form a resist pattern, but the present invention is not limited thereto. The present invention is widely adoptable in the cases where impurity is selectively implanted into a semiconductor substrate, or an object film formed on the semiconductor substrate; a mask for selectively depositing a thin film on a semiconductor substrate, or an object film formed on the semiconductor substrate is formed; and the like. For example, an organic polymer film or insulating film may be used in place of a resist film. As a polymer film, for example, a polyvinyl phenol film, polyimide film, or the like may be used, while as an insulating film, for example, a silicon dioxide film, silicon nitride film, or the like may be used.

## Claims

**1.** A pattern forming method comprising:

a resist film depositing step of depositing a resist film on an object film formed on a semiconductor substrate;
a charging step of selectively imparting a positive or negative electric charge to the surface of said resist film;
an inorganic compound film forming step of supplying an inorganic compound having an opposite charge to the charge which has been imparted in said charging step onto the entire surface of said resist film to cause the electrostatic adsorption of said inorganic compound on the surface of said resist film charged in said charging step, thereby selectively forming an inorganic compound film made of said inorganic compound on the surface of said resist film; and
an etching step of subjecting said resist film to dry etching by using said inorganic compound film as a mask to form a resist pattern made of said resist film.

**2.** A pattern forming method according to claim 1, wherein

said resist film in said resist depositing step comprises a resist material which generates a negative ion through irradiation with an energy beam;
said charging step includes a step of selectively irradiating the surface of said resist film with an energy beam to selectively generate a negative ion on the surface of said resist film; and
said inorganic compound film forming step includes a step of supplying an inorganic compound for generating a positive ion onto the entire surface of said resist film to cause the electrostatic adsorption of said inorganic compound in which a positive ion has been generated on the surface of said resist film in which a negative ion has been generated.

**3.** A pattern forming method according to claim 2, wherein

said resist film comprises a polymer having a negative ion generating group which generates a negative ion through irradiation with an energy beam.

**4.** A pattern forming method according to claim 3, wherein

said polymer having said negative ion generating group generates a sulfonic acid ion or a carboxylic acid ion through irradiation with an energy beam.

**5.** A pattern forming method according to claim 2, wherein

said inorganic compound is a compound having an amino group.

**6.** A pattern forming method according to claim 1, wherein

said resist film in said resist film depositing step comprises a resist material which generates a positive ion through irradiation with an energy beam;

said charging step includes a step of selectively irradiating the surface of said resist film with an energy beam to selectively generate a positive ion on the surface of said resist film; and

said inorganic compound film forming step includes a step of supplying an inorganic compound for generating a negative ion on the entire surface of said resist film to cause the electrostatic adsorption of said inorganic compound in which a negative ion has been generated on the surface of said resist film in which a positive ion has been generated.

**7.** A pattern forming method according to claim 6, wherein

said resist film comprises a polymer having a positive ion generating group which generates a positive ion through irradiation with an energy beam.

**8.** A pattern forming method according to claim 7, wherein

said polymer having said positive ion generating group generates an ammonium ion through irradiation with an energy beam.

**9.** A pattern forming method according to claim 6, wherein

said inorganic compound is a compound having a sulfonic group or a carboxylic group.

**10.** A pattern forming method according to claim 1, wherein

said inorganic compound film forming step includes a step of supplying a solution of said inorganic compound on the entire surface of said resist film.

**11.** A pattern forming method according to claim 1, wherein

said inorganic compound film forming step includes a step of supplying the vapor of said inorganic compound on the entire surface of said resist film.

**12.** A pattern forming method according to claim 1, wherein

said charging step includes a step of selectively implanting a positive or negative ion into the surface of said resist film to selectively impart a positive or negative electric charge to the surface of said resist film.

**13.** A semiconductor processing method comprising:

a thin film depositing step of depositing a thin film on a semiconductor substrate, or an object film formed on said semiconductor substrate;

a charging step of selectively imparting a positive or negative electric charge to the surface of said thin film;

a compound film forming step of supplying a compound having an opposite charge to the charge which has been imparted in said charging step onto the entire surface of said thin film to cause the electrostatic adsorption of said compound having said opposite charge on the surface of said thin film charged in said charging step, thereby selectively forming a compound film made of said compound on the surface of said thin film; and

a processing step of processing said semiconductor substrate or said object film by using said compound film as a mask.

**14.** A semiconductor processing method according to claim 13, wherein

said charging step includes a step of selectively implanting a positive or negative ion into the surface of said thin film to selectively impart a positive or negative electric charge to the surface of said thin film.

Fig. 1(a)

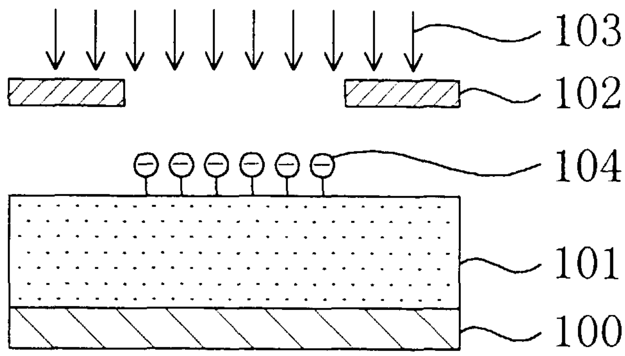


Fig. 1(b)

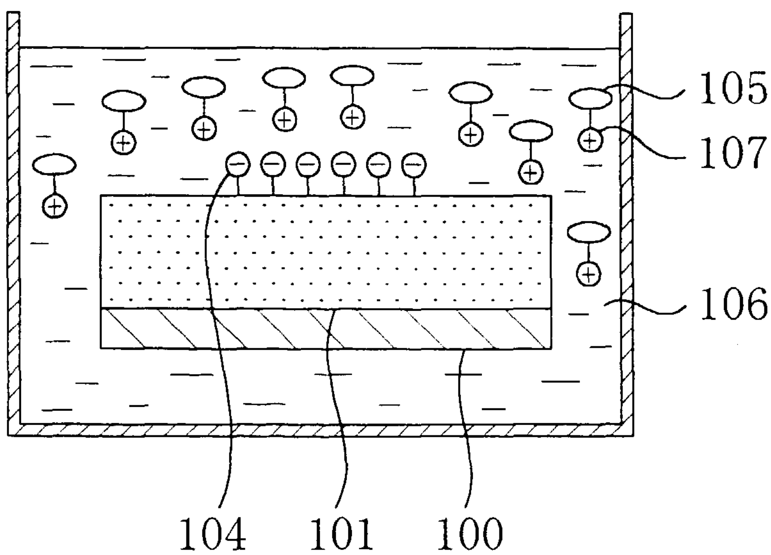

Fig. 2(a)

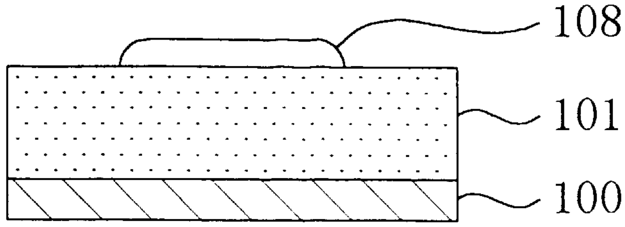


Fig. 2(b)

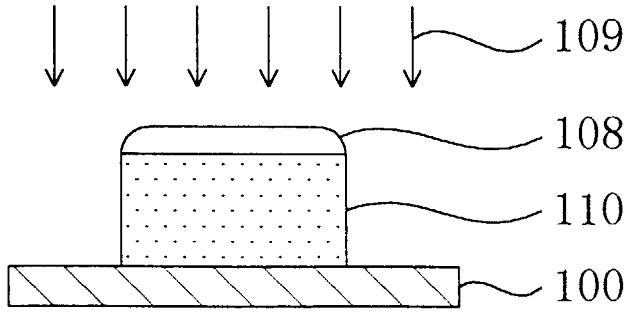

Fig. 3

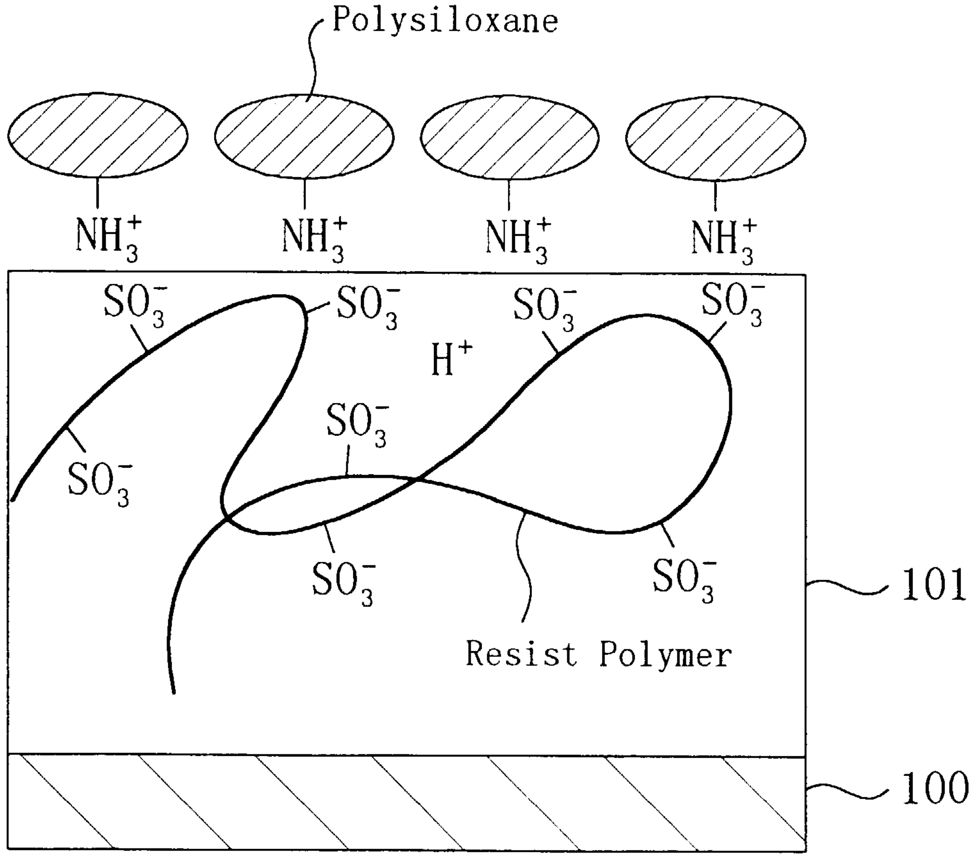
Polysiloxane
NH3+
NH3+
NH3+
NH3+
SO3-
SO3-
SO3-
SO3-
H+
SO3-
SO3-
SO3-
SO3-
Resist Polymer
101
100

Fig. 4

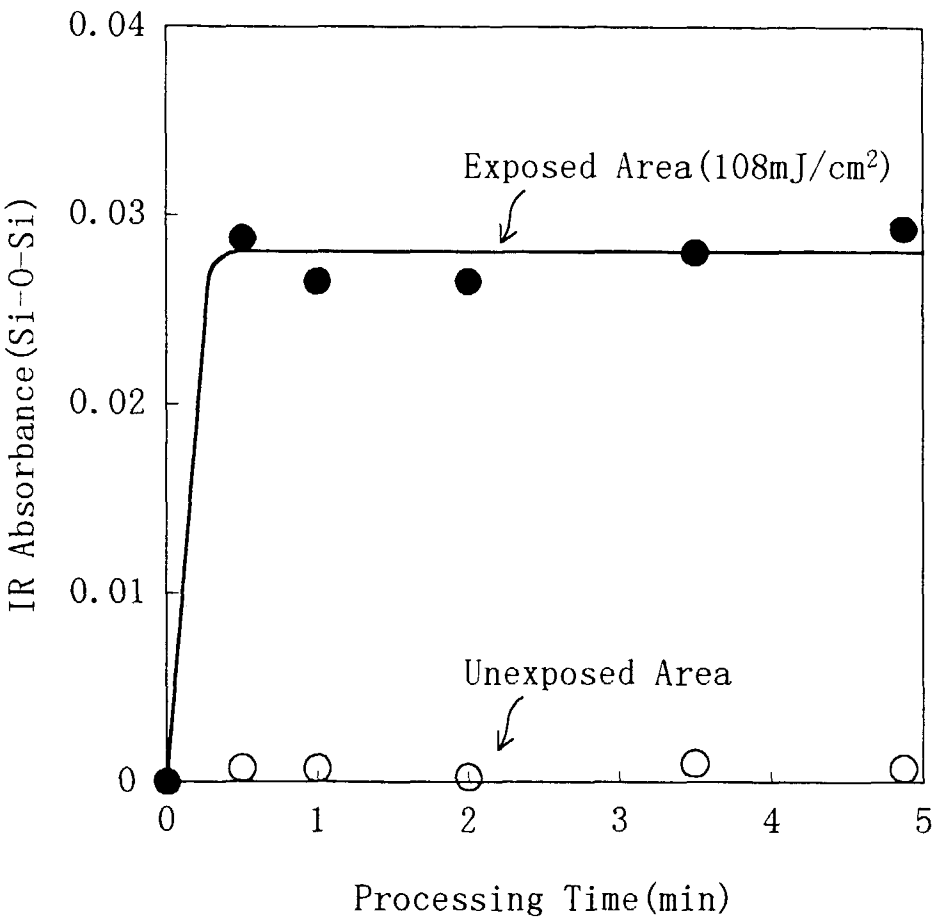

0.04
0.03
0.02
0.01
0
IR Absorbance(Si-O-Si)
Exposed Area(108mJ/cm2)
Unexposed Area
0
1
2
3
4
5
Processing Time(min)

Fig. 5

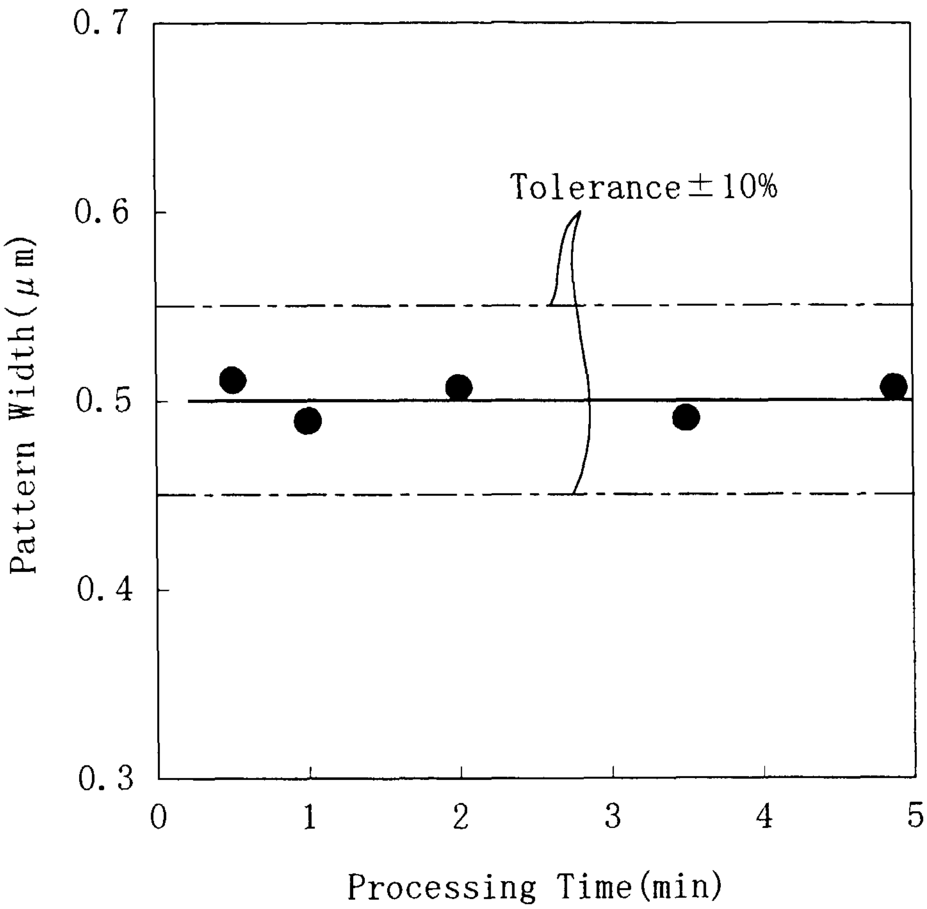
0.7
0.6
0.5
0.4
0.3
Pattern Width(μm)
Tolerance±10%
0
1
2
3
4
5
Processing Time(min)

Fig. 6(a)

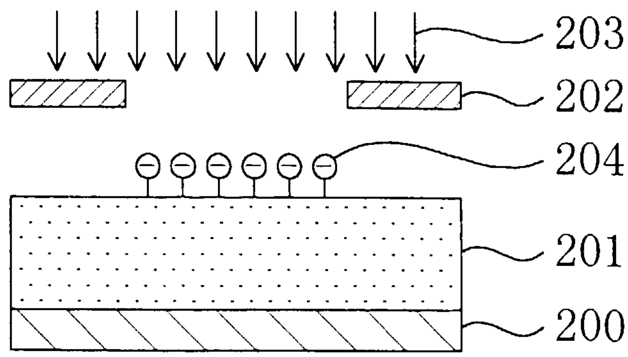


Fig. 6(b)

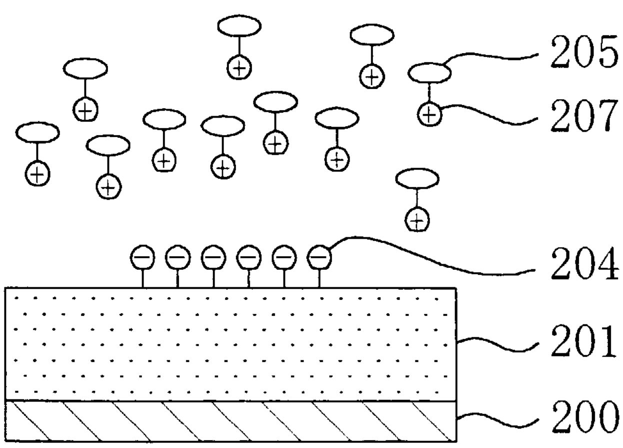

Fig. 7(a)

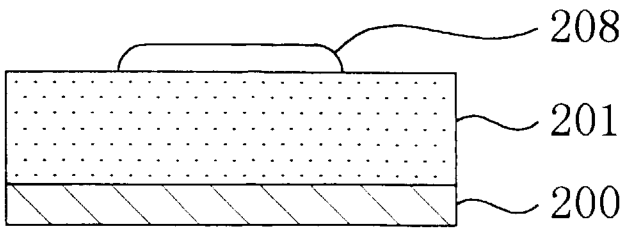


Fig. 7(b)

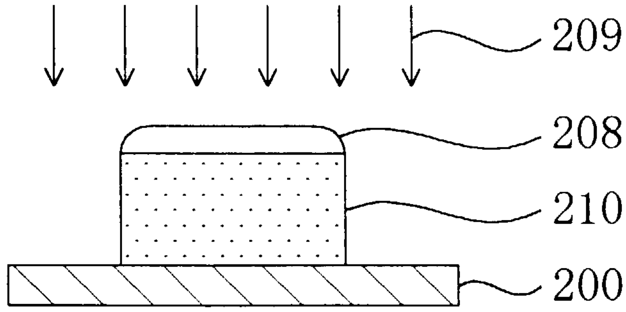

Fig. 8(a)

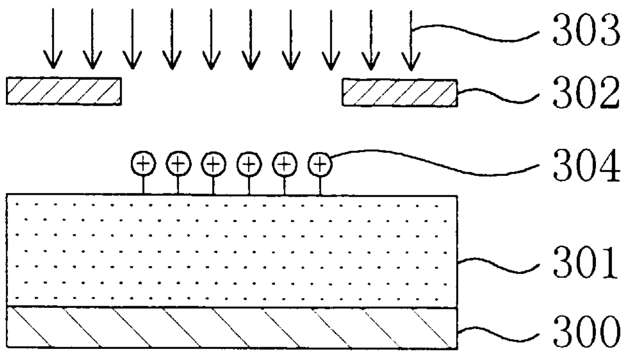


Fig. 8(b)

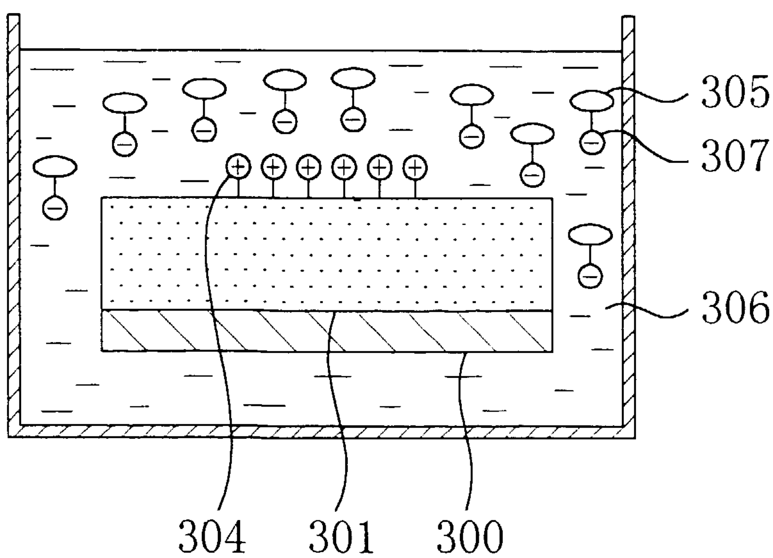

Fig. 9(a)

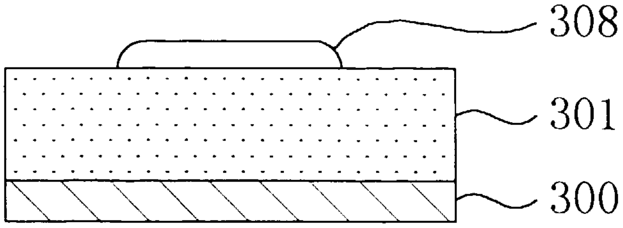


Fig. 9(b)

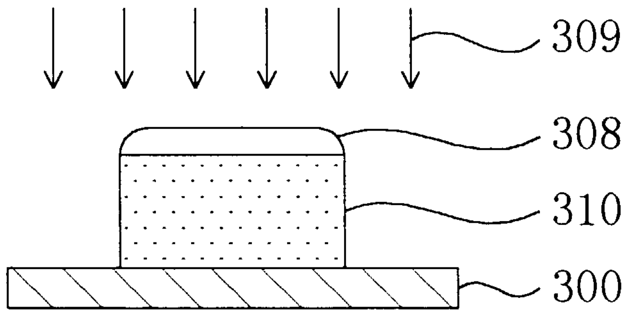

Fig. 10(a)

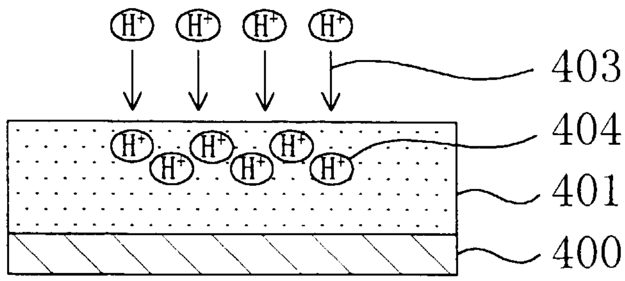


Fig. 10(b)

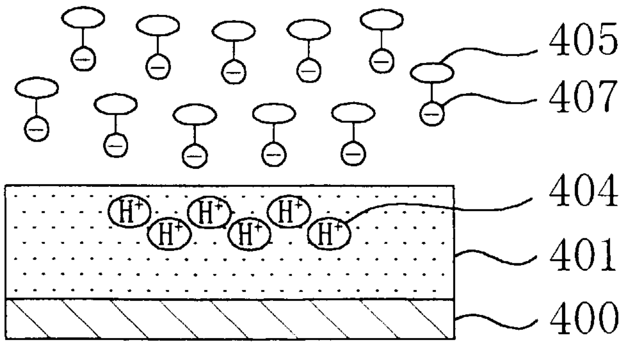

Fig. 11(a)

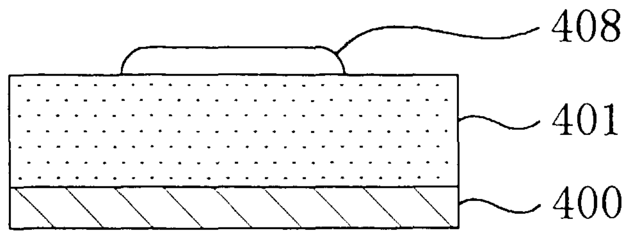


Fig. 11(b)

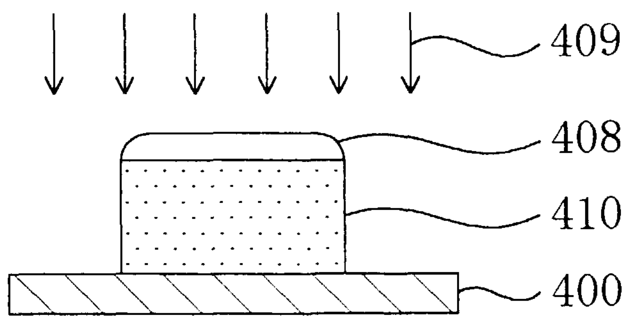

Fig. 12(a)
Prior Art

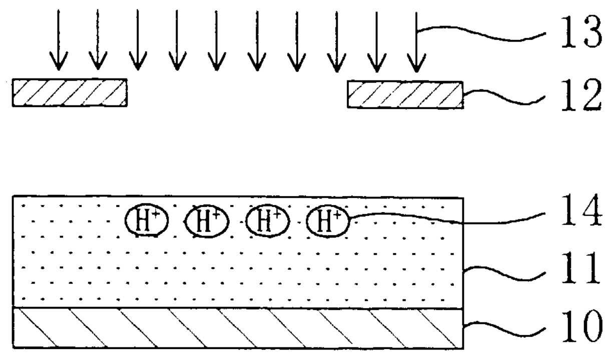


Fig. 12(b)
Prior Art

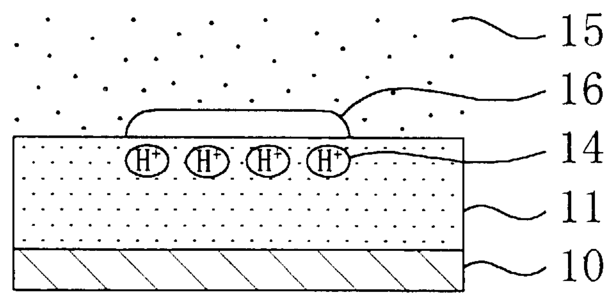


Fig. 12(c)
Prior Art

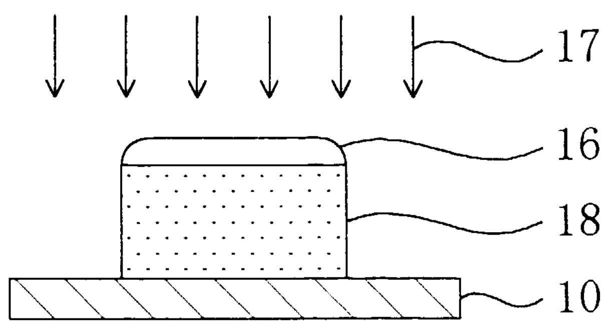

Fig. 13
Prior Art

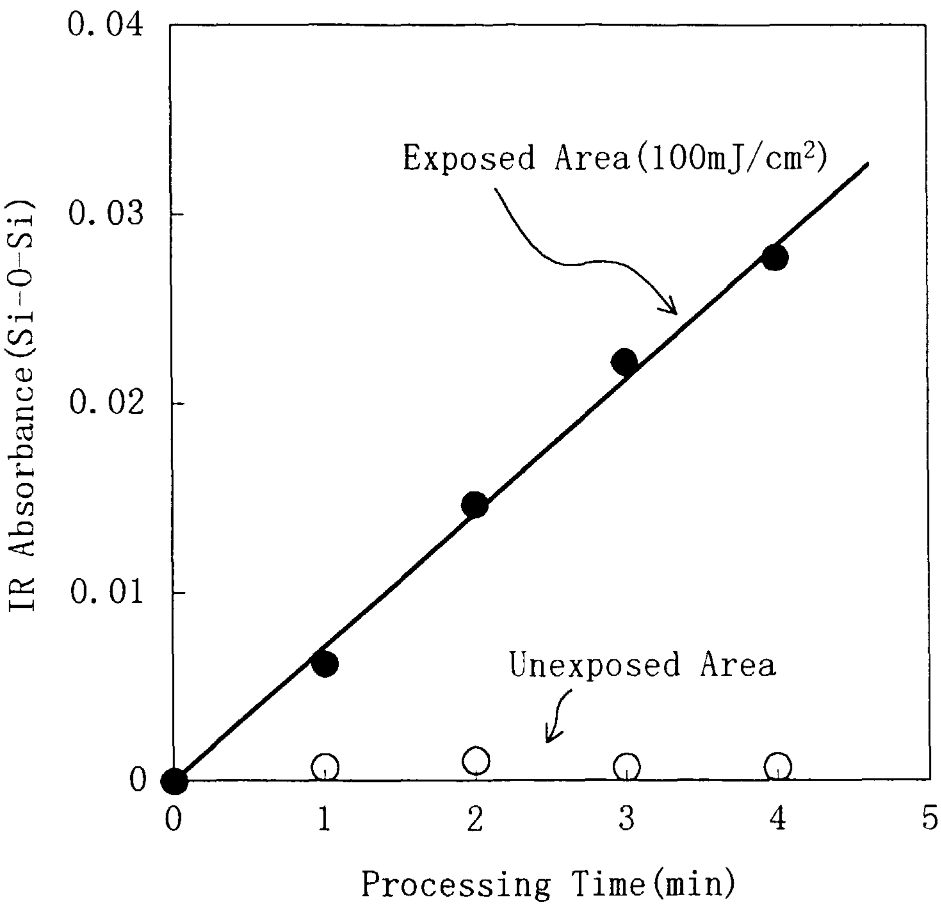

Fig. 14
Prior Art